Europäisches Patentamt

European Patent Office

Office européen des brevets

(19)

(11) **EP 0 874 450 A1**

(12) # DEMANDE DE BREVET EUROPEEN

(43) Date de publication:
**28.10.1998 Bulletin 1998/44**

(51) Int Cl.$^6$: **H03F 3/60**, H03F 1/52

(21) Numéro de dépôt: **98400965.4**

(22) Date de dépôt: **20.04.1998**

(84) Etats contractants désignés:
**AT BE CH CY DE DK ES FI FR GB GR IE IT LI LU MC NL PT SE**
Etats d'extension désignés:
**AL LT LV MK RO SI**

(30) Priorité: **24.04.1997 FR 9705070**

(71) Demandeur: **ALCATEL ALSTHOM COMPAGNIE GENERALE D'ELECTRICITE**
**75008 Paris (FR)**

(72) Inventeur: **Rivierre, Bernard**
**31470 Fontenilles (FR)**

(74) Mandataire: **Lamoureux, Bernard et al**
**Compagnie Financiere Alcatel,**
**Département D.P.I.,**
**30, avenue Kléber**
**75016 Paris (FR)**

(54) **Dispositif à amplificateurs de puissance à faible dégradation en cas de pannes**

(57)     L'invention est relative à un montage à amplificateurs de puissance comprenant, d'une part, N entrées ($12_1$...$12_4$) et N sorties ($22_1$...$22_4$), et, d'autre part, N voies d'amplification. Le montage est tel que toutes les voies d'amplification ont sensiblement la même puissance même si les signaux d'entrée ont des puissances différentes.

Chaque voie d'amplification comporte au moins une cellule (40) comprenant deux amplificateurs, de préfé-rence identiques, connectés aux premier et second ports d'un coupleur (68), dont un troisième port consti-tue la sortie (44) de la cellule (40). De préférence on prévoit aussi un coupleur d'entrée (54) dont un port constitue l'entrée de la cellule et dont deux autres ports sont reliés aux entrées des amplificateurs respectifs. Chaque cellule (40) comprend des moyens pour recom-biner les signaux sur des ports du coupleur de sortie (68) de façon à maximiser la puissance en sortie en cas de panne de l'un des amplificateurs.

FIG.2

EP 0 874 450 A1

## Description

La présente invention est relative à un dispositif à amplificateurs de puissance à faible dégradation en cas de pannes.

Dans certains domaines, en particulier les techniques spatiales, il est indispensable de réaliser les équipements de façon telle que les pannes, inévitables, de composants ou éléments n'entraînent pas de dégradation sensible du fonctionnement des équipements. Pour atteindre ce but, en général on fait fonctionner chaque composant ou élément à sa puissance optimale et on prévoit une redondance de ces composants ou éléments.

Ainsi, dans les satellites de télécommunication on utilise quelquefois un ensemble d'éléments rayonnants (d'émission ou réception) monofaisceaux dont chacun est alimenté par un signal d'amplitude et de phase bien déterminés. A chaque élément rayonnant est associé un (ou plusieurs) amplificateur(s) de puissance. Les amplitudes des signaux fournis aux éléments rayonnants pouvant varier, il n'est pas toujours possible de faire fonctionner l'amplificateur associé à sa puissance optimale. Pour que chaque amplificateur soit utilisé dans les meilleures conditions, on fait appel à un montage appelé "amplificateur multiportes".

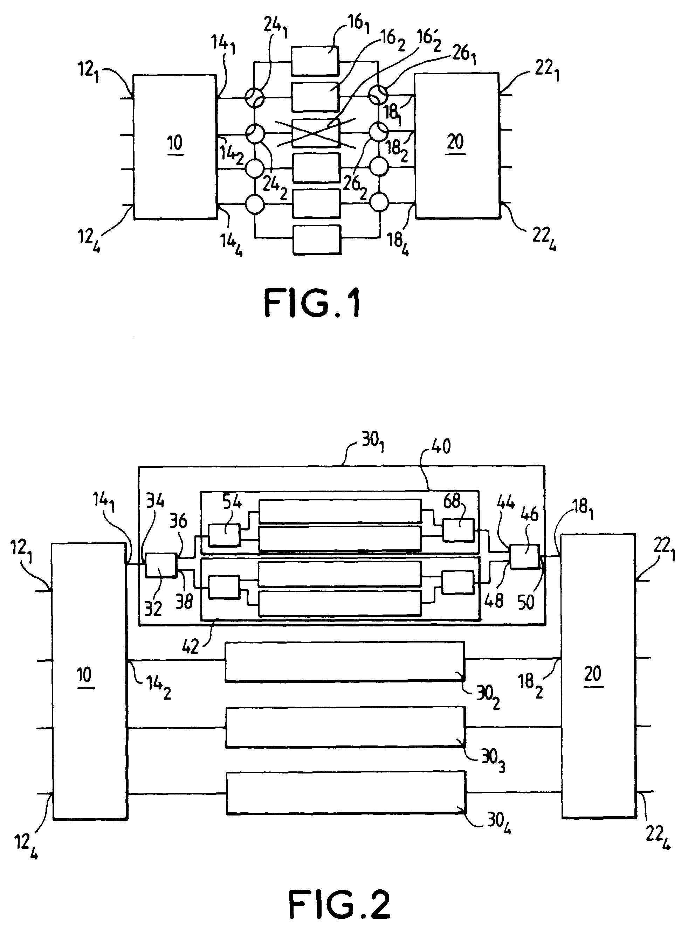

Un tel montage (Fig. 1) comporte une matrice de Butler d'entrée 10 comprenant un nombre de ports $12_1...12_n$ d'entrées égal au nombre d'éléments rayonnants (non montrés). La somme des puissances des signaux appliqués sur les entrées $12_1...12_4$ est en général constante. La matrice de Butler est telle qu'elle délivre sur ses sorties des signaux $14_1$ à $14_4$ (en nombre égal aux entrées) dont les puissances sont égales.

A chaque sortie $14_i$ de la matrice 10 est associé un amplificateur de puissance $16_i$ (ou un ensemble de tels amplificateurs) relié à une entrée $18_i$ d'une matrice de Butler de sortie 20. Cette dernière comporte des sorties $22_i$, dont chacune est connectée à un élément rayonnant. La matrice 20 de sortie a la fonction inverse de la matrice 10 d'entrée ; on retrouve ainsi, sur chaque sortie $22_i$, en amplitude (à un facteur d'amplification près) et en phase, le signal appliqué sur l'entrée $12_i$ correspondante.

Les amplificateurs $16_i$ fonctionnent tous à la même puissance. Cette puissance correspond, bien entendu, au point optimum de fonctionnement. Ils sont habituellement identiques entre eux. Pour prévenir les pannes, dans le montage connu, qui est représenté sur la figure 1, on prévoit des amplificateurs en surnombre. Ainsi, dans l'exemple le montage comporte six amplificateurs, alors que le nombre nécessaire est de quatre. Les amplificateurs en surnombre sont initialement non utilisés. En cas de panne, ils sont mis en circuit, grâce à des commutateurs $24_1$, $24_2$..., $26_1$, $26_2$... Par exemple, à l'origine, l'amplificateur $16'_2$ reliait la sortie $14_2$ de la matrice 10 à l'entrée $18_2$ de la matrice 20 ; après détection d'une panne sur cet amplificateur, les commutateurs $24_2$ et $26_2$ ont été commandés pour mettre hors circuit l'amplificateur $16'_2$, et mettre en circuit l'amplificateur $16_2$ qui était en réserve.

Les amplificateurs en réserve et les commutateurs - le plus souvent électromécaniques - constituent un surcroît gênant de masse. En outre, le remplacement d'un amplificateur par un autre entraîne une modification de phase due à la modification du parcours des signaux. Il en résulte une altération des signaux sur les sorties $22_i$ qui se traduit par une dégradation des diagrammes d'émission (ou réception) en direction et en amplitude.

L'état de la technique est également représenté par le document US 5 610 556, dans lequel le montage comporte, dans chaque voie, entre une sortie de la matrice d'entrée et l'entrée correspondante de la matrice de sortie, une cellule d'amplification comprenant deux amplificateurs identiques, connectés à deux ports d'entrées d'un coupleur dont un port de sortie est relié à l'entrée de la matrice de sortie.

Cependant ce dispositif ne permet pas d'optimiser la puissance de la cellule en cas de défaillance d'un amplificateur.

L'invention remédie à ces inconvénients. Elle permet de limiter le nombre d'amplificateurs et d'optimiser la puissance de la cellule en cas de défaillance d'un amplificateur.

Elle est caractérisée en ce que chaque cellule comporte des moyens pour recombiner les signaux sur les ports du coupleur de sortie, ces moyens étant disposés entre chaque amplificateur et le port correspondant du coupleur de sortie.

Ainsi, d'une part la puissance en sortie est maximisée et d'autre part, si l'un des amplificateurs de la cellule tombe en panne, la sortie du coupleur délivrera un signal dont la phase n'est pas modifiée. En cas d'application à une antenne d'émission, la perturbation sur la direction des diagrammes d'émission sera minimisée.

De préférence, chaque cellule comporte un coupleur d'entrée dont un port d'entrée est relié à la sortie correspondante de la matrice de Butler d'entrée et dont les ports de sorties sont reliés aux entrées des amplificateurs respectifs.

Selon un mode de réalisation, la polarisation de chaque amplificateur est modifiable ; ainsi en cas de panne d'un amplificateur, on modifie la polarisation de l'autre amplificateur afin qu'il délivre une puissance supérieure.

Selon un autre mode de réalisation, un commutateur, par exemple à diode PIN, est en série entre la sortie de chaque amplificateur et le port d'entrée correspondant du coupleur, et le second port de sortie du coupleur débite dans une impédance par l'intermédiaire d'un autre commutateur. En cas de panne d'un amplificateur, le commutateur en série avec cet amplificateur est commandé pour que le port d'entrée correspondant du coupleur débite dans un court-circuit, et le commutateur de sortie est commandé pour que le second port de sortie du coupleur, selon l'amplificateur en panne, soit débite sur un court-circuit, soit est relié à un circuit ouvert.

Une même voie peut comporter plusieurs cellules en parallèle. Par exemple, si une voie comporte deux cellules en parallèle celles-ci forment un module comportant un coupleur d'entrée et un coupleur de sortie, chaque cellule dans ce module jouant le même rôle que chaque amplificateur dans une cellule.

Si les deux amplificateurs d'une cellule tombent en panne, il restera la cellule restante. Si des moyens de recombinaison des signaux du coupleur de sortie du module sont prévus, le fonctionnement est le même que pour une cellule dans laquelle un amplificateur tombe en panne.

L'invention n'est pas limitée à un amplificateur multiportes. Elle s'étend aussi à une cellule ou un module de puissance.

Son application préférée vise l'amplification de signaux en des emplacements où les réparations sont pratiquement impossibles tels que les satellites ou véhicules spatiaux.

D'autres caractéristiques et avantages de l'invention apparaîtront avec la description de certains de ses modes de réalisation, celle-ci étant effectuée en se référant aux dessins ci-annexés sur lesquels :

la figure 1, déjà décrite, représente un amplificateur multiportes connu ;
la figure 2 est un schéma d'un montage selon l'invention ;
la figure 3 est un schéma d'une cellule du montage de la figure 2, cette cellule étant représentée dans son état de fonctionnement nominal, et
les figures 4 et 5 sont des schémas analogues à celui de la figure 3, mais pour des fonctionnements dégradés.

On se réfère tout d'abord à la figure 2.

L'amplificateur multiportes représenté sur la figure 2 comporte, comme un amplificateur multiportes classique (figure 1), une matrice de Butler d'entrée 10 et une matrice de Butler de sortie 20 ayant la même fonction que les matrices correspondantes, de mêmes références, de l'amplificateur multiportes classique.

Un module de puissance $30_i$ est disposé entre chaque sortie $14_i$ de la matrice 10 et l'entrée correspondante $18_i$ de la matrice 20. Sur la figure 2, le module $30_1$ a été représenté dans son ensemble de façon schématique tandis que les autres modules, $30_2$, $30_3$ et $30_4$, ont été représentés par de simples blocs.

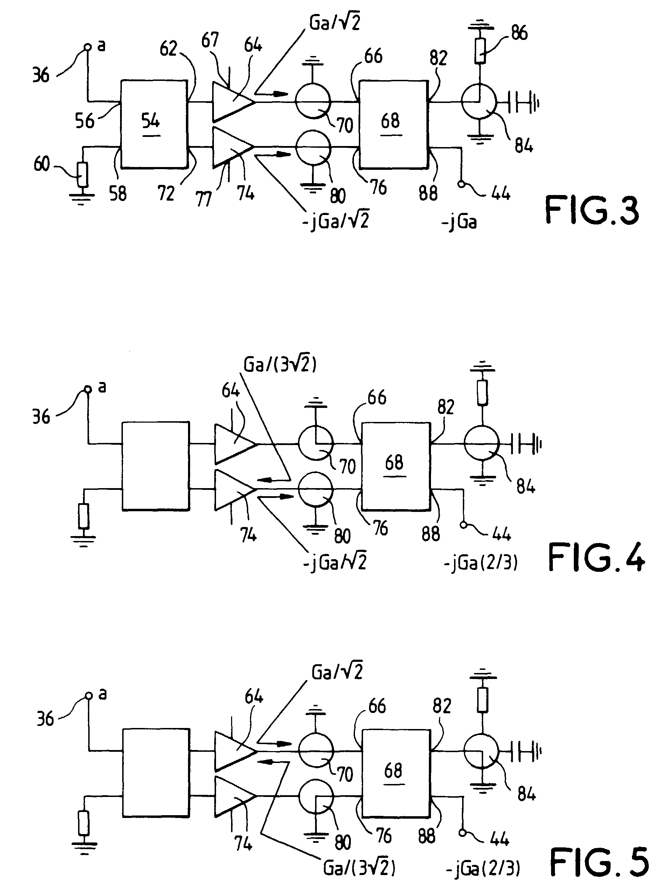

Le module 301 comporte un coupleur d'entrée 32 de type trois décibels (dB) et déphasage 90° à deux ports d'entrée et deux ports de sortie. La première entrée 34 reçoit le signal de la sortie $14_1$ de la matrice 10, tandis que la deuxième entrée (non représentée) est reliée à la masse par l'intermédiaire d'une impédance, de façon analogue à ce qui sera décrit plus loin en relation avec les figures 3 à 5. La première sortie 36 du coupleur 32 est reliée à l'entrée d'une première cellule 40, tandis que la seconde sortie 38 de ce coupleur est connectée de l'entrée d'une seconde cellule 42 identique à la cellule 40. La cellule 40 sera décrite plus loin en relation avec les figures 3, 4 et 5.

La sortie de la cellule 40 est reliée à la première entrée 44 d'un coupleur (3dB, 90°) 46, tandis que la sortie de la cellule 42 est connectée à la seconde entrée 48 de ce coupleur 46. Une sortie 50 du coupleur 46 est reliée à l'entrée $18_1$ de la matrice de Butler 20. Le coupleur 46 présente, par ailleurs, une seconde sortie (non représentée) qui est connectée de la même manière que la seconde sortie du coupleur de la cellule 40, comme décrit plus loin en relation avec les figures 3 à 5.

On se réfère maintenant à la figure 3 qui représente la cellule 40.

Cette cellule 40 comprend un coupleur (3dB, 90°) d'entrée 54, dont une première entrée 56 reçoit le signal provenant de la sortie 36 du coupleur 32 (figure 1). La seconde entrée 58 du coupleur 54 est reliée à la masse par l'intermédiaire d'une impédance 60 de valeur 50 Ohms.

La première sortie 62 du coupleur 54 est reliée à l'entrée d'un premier amplificateur 64 présentant une entrée 67 de commande de sa polarisation (ou de son gain). La sortie de cet amplificateur 64 est reliée à la première entrée 66 d'un coupleur de sortie 68 (3dB, 90°) par l'intermédiaire d'un commutateur 70, par exemple à diode PIN.

De même, la seconde sortie 72 du coupleur 64 est reliée à l'entrée d'un amplificateur 74 comprenant une entrée de commande de polarisation ou de gain. La sortie de cet amplificateur est reliée à la seconde entrée 76 du coupleur 68 par l'intermédiaire d'un commutateur 80, par exemple à diode PIN.

Une sortie 82 du coupleur 68 est reliée à la masse par l'intermédiaire d'un commutateur 84 et d'une impédance 86 de valeur 50 Ohms. L'autre sortie 88 du coupleur 68 est reliée à l'entrée 44 du coupleur 46 (figure 2).

Les connexions réalisées par les commutateurs 70, 80 et 84, qui ont été décrites ci-dessus, correspondent au fonctionnement nominal de la cellule, c'est-à-dire quand cette dernière n'est pas en panne, les deux amplificateurs 64 et 74 fonctionnant correctement.

A chaque sortie d'un amplificateur 64 et 74 est associé un détecteur (non représenté) fournissant une indication sur le niveau du signal de sortie. Ces détecteurs sont associés à des moyens de commande (non montrés) permettant de modifier la position des commutateurs 70, 80 et 84. Cette modification dépend de l'amplificateur, 64 ou 74, qui tombe en panne.

La figure 4 correspond à une panne de l'amplificateur 64, tandis que la figure 5 correspond à une panne de l'amplificateur 74.

Quand l'amplificateur 64 est en panne (figure 4), la sortie de ce dernier est déconnectée de l'entrée 66 du coupleur 68 et le commutateur 70 est positionné de façon telle que l'entrée 66 soit reliée directement à la masse, c'est-à-dire qu'elle soit en court-circuit. Par contre, la position du commutateur 80 n'est pas modifiée, c'est-à-dire que la sortie de l'amplificateur 74 reste reliée à l'entrée 76 du coupleur 68. Enfin, la sortie 82 du coupleur 68 est déconnectée de l'impédance 86. Elle reste en circuit ouvert, grâce à une commande correspondante du commutateur 84.

Quand c'est l'amplificateur 74 qui tombe en panne (figure 5), la sortie de ce dernier est déconnectée de l'entrée 76 du coupleur 68 et cette dernière, grâce à une commande correspondante du commutateur 80, est reliée à la masse. Par contre, la sortie de l'amplificateur 64 reste connectée à l'entrée 66 du coupleur 68.

Enfin, le commutateur 84 est positionné de façon telle que la sortie 82 soit en court-circuit, c'est-à-dire soit connectée à la masse.

En fonctionnement nominal (figure 3), quand un signal de valeur a est appliqué sur l'entrée 56 du coupleur 54, sur la sortie 62 il apparaît un signal $\frac{a}{\sqrt{2}}$ et sur la sortie 72 un signal $\frac{-ja}{\sqrt{2}}$, j étant le nombre imaginaire tel que : $j^2 = -1$.

Dans ces conditions, sur la sortie de l'amplificateur 64, on obtient un signal $\frac{Ga}{\sqrt{2}}$ et sur la sortie de l'amplificateur 74, on obtient un signal $\frac{-jGa}{\sqrt{2}}$ G étant le gain de chacun des amplificateurs 64 et 74.

Sur la sortie 88 du coupleur 68, le signal obtenu a pour valeur -jGa. Ce signal est donc en quadrature avec le signal a sur l'entrée 36.

Si, quand l'un des amplificateurs 64 ou 74 tombe en panne, les commutateurs 70, 80 et 84 restent dans la position représentée sur la figure 3, on obtient sur la borne 44 un signal de valeur $\frac{-jGa}{\sqrt{2}}$. Ainsi, il s'agit encore d'un signal en quadrature avec le signal d'entrée a, mais la puissance de ce signal est le quart de la puissance obtenue en fonctionnement nominal, alors que la capacité du montage a été seulement divisée par deux.

C'est pourquoi, en cas de panne, on préfère commander les interrupteurs comme décrit ci-dessus en relation avec les figures 4 et 5.

Comme expliqué plus loin, dans chacun des deux cas représentés sur ces figures 4 et 5, on obtient sur la sortie 88 un signal de valeur -jGa. $\frac{2}{3}$. Dans ces conditions la puissance restituée est les 4/9 de la puissance du signal de sortie en fonctionnement nominal (figure 3).

Cette fraction de 4/9 est proche de 50 % qui est le maximum théorique que l'on pourrait obtenir avec la panne de l'un des amplificateurs.

La valeur -jGa. $\frac{2}{3}$ obtenue en sortie 88 du coupleur 68 dans le cadre des figures 4 et 5 s'explique par les considérations et calculs suivants :

Un coupleur 3dB, 90° présente quatre ports, dont chacun constitue une entrée/sortie. Sur chaque port de numéro i il entre un signal $a_i$ et il sort un signal de sortie $b_i$.

Un coupleur est tel qu'il existe la relation matricielle suivante entre les signaux entrants et sortants :

$$(1) \quad \begin{pmatrix} b_1 \\ b_2 \\ b_3 \\ b_4 \end{pmatrix} = \frac{1}{\sqrt{2}} \begin{pmatrix} 0 & 1 & 0 & \pm j \\ 0 & 0 & \pm j & 1 \\ 0 & \pm j & 0 & 1 \\ \pm j & 0 & 1 & 0 \end{pmatrix} \cdot \begin{pmatrix} a_1 \\ a_2 \\ a_3 \\ a_4 \end{pmatrix}$$

Pour un coupleur donné tous les nombres j de la matrice 4 x 4 ci-dessus sont affectés du même signe (+ ou -).

On applique la relation (1) ci-dessus au coupleur 68 dans le cas de la figure 4 (amplificateur 64 en panne), en adoptant les notations suivantes : les signaux $a_1$ et $b_1$ apparaissent sur le port 66, les signaux $a_2$ et $b_2$ apparaissent sur le port 82, les signaux $a_3$ et $b_3$ apparaissent sur le port 76 et les signaux $a_4$ et $b_4$ apparaissent sur le port 88.

Le signal de sortie $b_4$ sur le port 88 a pour valeur :

$$(2) \quad b_4 = \frac{1}{\sqrt{2}} (-ja_1 + a_3)$$

En tenant compte du fait que :

(3) $a_1 = r_1 b_1$, $r_1$ étant le coefficient de réflexion sur le port 66, et

$$(4) \qquad b_1 = \frac{1}{\sqrt{2}} (a_2 + ja_4) = \frac{1}{\sqrt{2}} a_2 = \frac{1}{\sqrt{2}} r_2 b_2 = \frac{1}{\sqrt{2}} r_2 \frac{1}{\sqrt{2}} (a_1 - ja_3)$$

$r_2$ étant le coefficient de réflexion sur le port 82, on obtient donc :

$$(5) \qquad b_4 = \frac{1}{\sqrt{2}} \left[ -j \left[ \frac{r_1}{\sqrt{2}} \cdot \frac{r_2}{\sqrt{2}} \left( a_1 - ja_3 \right) \right] + a_3 \right]$$

Soit :

$$b_4 = \frac{1}{\sqrt{2}} [ -j \frac{r_1 r_2}{2} a_1 + a_3 (1 - \frac{r_1 r_2}{2}) .$$

Des formules (2) et (5) ci-dessus, on déduit :

$$(6) \qquad -ja_1 + a_3 = -j \frac{r_1 r_2}{2} a_1 + a_3 (1 - \frac{r_1 r_2}{2})$$

soit :

$$-ja_1 ( 1 - \frac{r_1 r_2}{2} ) = -a_3 \frac{r_1 r_2}{2}$$

d'où :

$$a_1 = -ja_3 \frac{\frac{r_1 r_2}{2}}{1 - \frac{r_1 r_2}{2}} = -ja_3 \frac{r_1 r_2}{2 - r_1 r_2} ,$$

il en résulte :

$$b_4 = \frac{a_3}{\sqrt{2}} ( 1 - \frac{r_1 r_2}{2 - r_1 r_2} ) = \frac{a_3}{\sqrt{2}} ( \frac{2 - 2r_1 r_2}{2 - r_1 r_2} ) ;$$

étant donné que : $r_1 = 1$ (port 66 en court circuit), et $r_2 = -1$ (port 82 en circuit ouvert) :

$$b_4 = \frac{4a_3}{3\sqrt{2}}$$

comme $a_3 = -j \frac{Ga}{\sqrt{2}}$, on obtient bien :

$$b_4 = -jGa . \frac{2}{3}$$

Dans le cas de la figure 5, toujours à l'aide de la relation (1), on obtient :

$$(7) \quad b_2 = \frac{1}{\sqrt{2}} (a_1 - ja_3) = \frac{1}{\sqrt{2}} (a_1 - \frac{r_2 r_3}{\sqrt{2}} b_2)$$

Dans cette formule $r_2$ est le coefficient de réflexion sur le port 82 et $r_3$ est le coefficient de réflexion sur le port 76. De cette formule il résulte :

$$(8) \quad b_2 = a_1 \frac{\sqrt{2}}{2 + r_2 r_3}$$

Par ailleurs, le signal $b_4$ satisfait à la relation suivante :

$$(9) \quad b_4 = \frac{1}{\sqrt{2}} (-ja_1 + a_3) = \frac{1}{\sqrt{2}} ( -ja_1 - jb_2 \frac{r_2 r_3}{\sqrt{2}} )$$

soit

$$b_4 = - \frac{j}{\sqrt{2}} (a_1 + \frac{r_2 r_3}{\sqrt{2}} b_2) ;$$

d'où :

$$b_4 = \frac{j}{\sqrt{2}} a_1 ( 1 + \frac{r_2 r_3}{2 + r_2 r_3} ) = - \frac{j}{\sqrt{2}} a_1 ( \frac{2 + 2r_2 r_3}{2 + r_2 r_3} )$$

étant donné que : $r_2 = r_3 = 1$, on en déduit :

$$b_4 = - \frac{j}{\sqrt{2}} \frac{4}{3} a_1$$

comme $a_1 = \frac{Ga}{\sqrt{2}}$, il s'ensuit : $b_4 = -jGa. \frac{2}{3}$

Dans tous les cas, on obtient sur la sortie 88 un signal qui a toujours la même phase, c'est-à-dire en quadrature par rapport au signal a sur l'entrée 56.

Par contre, une diminution de l'amplitude du signal par rapport au fonctionnement nominal modifie les signaux obtenus en sorties $22_1$ à $22_4$ de la matrice 20 (figure 2). Pour minimiser cette altération des signaux en sortie de la matrice 20, on agit sur l'entrée de commande de polarisation 67 ou 77 de l'amplificateur 64 ou 74 qui reste en état de marche. L'augmentation de la polarisation augmente la puissance de sortie. Toutefois, en général, l'augmentation de puissance qui en résulte ne sera pas suffisante pour compenser la perte résultant de la panne.

Comme indiqué ci-dessus, le coupleur 46 (figure 2) est associé à des commutateurs (non montrés) analogues aux commutateurs 70, 80 et 84 associés au coupleur 68 de la cellule 40 ou 42.

Dans ces conditions, quand les deux amplificateurs 64 et 74 de la cellule 40 tombent en panne, les commutateurs associés au coupleur 46 se mettent dans la même position que les commutateurs 70, 80 et 84 dans le cadre de la figure 4.

De façon analogue, quand les deux amplificateurs de la cellule 42 tombent en panne, les commutateurs associés au coupleur 46 se mettent dans la même position que les commutateurs 70, 80 et 84 de la figure 5.

Il est à noter que, dans une même voie, entre des bornes $14_i$ et $18_i$, on peut associer deux modules 301 avec encore d'autres coupleurs d'entrées et de sorties (non montrés).

On a constaté que malgré la diminution de puissance pouvant résulter des pannes, l'invention permet de conserver dans des proportions acceptables les relations de phases entre les signaux sur les sorties $22_1$ à $22_4$ de la matrice 20, c'est-à-dire de conserver l'isolation nécessaire entre les divers diagrammes d'émission (ou de réception) d'une antenne.

**Revendications**

1. Montage à amplificateurs de puissance comprenant, d'une part, N entrées ($12_1...12_4$) et N sorties ($22_1...22_4$), et, d'autre part, N voies d'amplification, le montage étant tel que toutes les voies d'amplification ont sensiblement la même puissance même si les signaux d'entrée ont des puissances différentes, chaque voie d'amplification comportant au moins une cellule (40) comprenant deux amplificateurs (64, 74), de préférence identiques, connectés aux premier et second ports d'un coupleur (68), dont un troisième port (88) constitue la sortie (44) de la cellule (40), caractérisé en ce que chaque cellule (40) comprend des moyens (70, 80, 84) pour recombiner les signaux sur des ports (66, 76, 82) du coupleur de sortie (68) de façon à maximiser la puissance en sortie (88) en cas de panne de l'un des amplificateurs (64, 74), ces moyens étant disposés entre chaque amplificateur (64, 74) et le port correspondant (66, 76) du coupleur de sortie (68).

2. Montage selon la revendication 1, caractérisé en ce que chaque cellule comprend un coupleur d'entrée (54) dont un port (56) constitue l'entrée de la cellule et dont deux autres ports (62, 72) sont reliés aux entrées des amplificateurs respectifs (64, 74).

3. Montage selon la revendication 1 ou 2, caractérisé en ce qu'un commutateur (70, 80) est disposé entre chaque amplificateur (64, 74) et le port correspondant (66, 76) du coupleur de sortie (68), le commutateur correspondant à l'amplificateur en panne étant mis dans une position telle que le port correspondant du coupleur de sortie (68) soit en court-circuit.

4. Montage selon la revendication 3, caractérisé en ce que le quatrième port (82) du coupleur de sortie (68) débite dans une impédance (86) par l'intermédiaire d'un troisième commutateur (84).

5. Montage selon la revendication 4, caractérisé en ce que le troisième commutateur (84) du coupleur de sortie (68) est agencé pour mettre cette sortie (82) en court-circuit ou en circuit ouvert selon l'amplificateur (64, 74) en panne.

6. Montage selon l'une quelconque des revendications 3 à 5, caractérisé en ce que lesdits commutateurs sont du type à diode(s) PIN.

7. Montage selon l'une quelconque des revendications précédentes, caractérisé en ce que chaque amplificateur d'une cellule (40) comporte une entrée (67, 77) de commande de polarisation, et en ce que des moyens sont prévus pour augmenter la puissance d'un amplificateur en état de marche quand l'autre amplificateur est en panne.

8. Montage selon l'une quelconque des revendications précédentes, caractérisé en ce que chaque voie d'amplification comporte au moins deux cellules (40, 42) en parallèle.

9. Montage selon la revendication 8, caractérisé en ce que les deux cellules (40, 42) en parallèle sont connectées à des ports respectifs (44, 48) d'un coupleur (46).

10. Montage selon la revendication 9, caractérisé en ce qu'il comporte un coupleur d'entrée (32) dont deux ports (36, 38) sont connectés aux entrées respectives des cellules (40, 42).

11. Montage selon la revendication 9 ou 10, caractérisé en ce que des moyens sont prévus pour recombiner les signaux sur des ports du coupleur (46) recevant les signaux de sortie des cellules (40, 42), de façon à maximiser la puissance en sortie de ce coupleur (46) en cas de pannes simultanées des deux amplificateurs de l'une des cellules.

12. Montage selon l'une quelconque des revendications précédentes, caractérisé en ce qu'un coupleur (54, 68, 32, 46) présente quatre ports par chacun desquels entre un signal $a_i$ et sort un signal $b_i$, ces signaux étant liés par la relation suivante :

$$(1) \quad \begin{pmatrix} b_1 \\ b_2 \\ b_3 \\ b_4 \end{pmatrix} = \frac{1}{\sqrt{2}} \begin{pmatrix} 0 & 1 & 0 & \pm j \\ 0 & 0 & \pm j & 1 \\ 0 & \pm j & 0 & 1 \\ \pm j & 0 & 1 & 0 \end{pmatrix} \cdot \begin{pmatrix} a_1 \\ a_2 \\ a_3 \\ a_4 \end{pmatrix}$$

j étant le nombre imaginaire tel que : $j^2 = -1$

13. Montage selon l'une quelconque des revendications précédentes, caractérisé en ce qu'il comporte une matrice de Butler d'entrée (10) et une matrice de Butler de sortie (20).

14. Application du montage selon l'une quelconque des revendications précédentes à l'alimentation d'éléments rayonnants, de préférence d'une antenne embarquée sur satellite ou véhicule spatial.

FIG.1

FIG.2

FIG.3

FIG.4

FIG.5

EP 0 874 450 A1

**Office européen des brevets**

## RAPPORT DE RECHERCHE EUROPEENNE

Numéro de la demande

EP 98 40 0965

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | US 5 610 556 A (RUBIN MICHAEL D) 11 mars 1997<br>* colonne 7, ligne 4 - colonne 8, ligne 2; figures 7A,7B * | 1,2,8-12 | H03F3/60<br>H03F1/52 |
| A | US 4 010 426 A (RAMBO SHELDON I) 1 mars 1977<br>* le document en entier * | 1,2 | |
| A | FR 2 284 226 A (THOMSON CSF) 2 avril 1976<br>* page 4, ligne 5 - page 5, ligne 18; figures 2,3 * | 3,4,6 | |
| A | PATENT ABSTRACTS OF JAPAN<br>vol. 009, no. 027 (E-294), 6 février 1985<br>& JP 59 172816 A (NIPPON DENKI KK), 29 septembre 1984,<br>* abrégé * | 1,3,5,6 | |
| A | US 5 083 094 A (FORSBERG BJORN G) 21 janvier 1992<br>* le document en entier * | 1,7,8 | |

**DOMAINES TECHNIQUES RECHERCHES (Int.Cl.6)**

H03F

Le présent rapport a été établi pour toutes les revendications

| Lieu de la recherche | Date d'achèvement de la recherche | Examinateur |
|---|---|---|
| LA HAYE | 8 juillet 1998 | Tyberghien, G |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03 82 (P04C02)